# EUROPEAN PATENT APPLICATION

(11) **EP 4 618 719 A1**
(43) Date of publication of application: **17.09.2025**
(21) Application number: 25158817.4
(22) Date of filing: 19.02.2025
(51) Int. Cl.: H10D 62/10, H10D 62/40, H01L 21/04, H10D 62/57, H10D 30/66, H10D 62/832

(54) **POWER MOSFET PROVIDED WITH A VARIABLE TRANSPARENCY EDGE RING FORMED BY A HIGH-DEPTH AUTO-ALIGNED IMPLANT**

(30) Priority: 14.03.2024 IT 202400005770
(71) Applicant: STMicroelectronics International N.V., 1228 Plan-les-Ouates, Geneva (CH)
(72) Inventor: GUARNERA, Alfio, 95039 TRECASTAGNI (CT) (IT); CAMALLERI, Cateno Marco, 95125 CATANIA (IT); ZANETTI, Edoardo, 95028 VALVERDE (CT) (IT); SCALIA, Laura Letizia, 95037 SAN GIOVANNI LA PUNTA (CT) (IT); SAGGIO, Mario Giuseppe, 95020 ACI BONACCORSI (CT) (IT)
(74) Representative: Studio Torta S.p.A.

(57) **Abstract**

Method for manufacturing an electronic device (40), comprising the steps of: arranging a semiconductor body (50) of N-type, having a lattice structure with spatial symmetry; forming, in the semiconductor body, a damaged region (80a) having an amorphous structure or a structure with no spatial symmetry; forming an edge termination region (68) of P-type in the semiconductor body (50) including performing a channelized implant of P-type doping species at the damaged region and at portions of the semiconductor body adjacent to the opposite sides of the damaged region.

## Description

The invention relates to an electronic device and a manufacturing method thereof, in particular a method to form an edge ring which at least partially surrounds an active area of the electronic device by exploiting intentionally damaged regions to obtain an implant of the edge ring in an auto-aligned manner.

Ion implant is nowadays a well-established technique for introducing dopants into Silicon Carbide, SiC, since dopant spreading is not an applicable technique due to the low diffusivity of SiC compared to other semiconductor materials (such as, for example, Silicon), and epitaxial growth might not be a useful alternative, particularly for locally confined volumes.

As known, the crystalline structure of SiC affects, during implant, the depth distribution obtained. In fact, the so-called channeling may considerably increase the penetration depth of the ions into the crystalline material with respect to an amorphous target. This phenomenon may occur if the direction of the impinging ion beam is nearly parallel to the main crystallographic axes or planes. In these directions, the reduction in energy loss per ion pathlength is smaller and thus the ions move deeper into the target.

In order to theoretically describe the probability of channeling, the concept of "critical channeling angle" has been introduced. In this case, the critical angle is considered as the maximum angle between the axial rows of atoms and the incoming beam at which the ions will still be guided along that axis. To investigate and predict the channeling phenomena during ion implant, nowadays there exists different software for Monte Carlo simulation in crystalline targets, for example using the binary collision approximation (MC-BCA).

Channeling is often an undesired effect, and generally, the SiC wafer is tilted in a random, non-channeling direction to minimize the channeling effects during implant. Doping profiles more or less Gaussian with respect to depth are thus obtained, where the depth is determined by the energy, the ions used and the target atomic structure. On the other hand, if the implant is performed along a crystallographic axis, a completely different profile will be obtained wherein the ions follow the direction of the crystal in depth into the target. In SiC, it has been demonstrated that the deepest channeled ions may penetrate the expected action range many times for the corresponding random implant.

In order to form locally confined implanted regions, it is known to use an implant hard masks, for example of silicon oxide (SiO₂), configured to locally shield the SiC wafer during the implant step. However, the Applicant has verified that using hard masks of the aforementioned type may cause planarity problems of the layer having the mask applied thereto, after removing the same mask, due to the lattice stress effect generated on the SiC substrate by the presence of this hard mask.

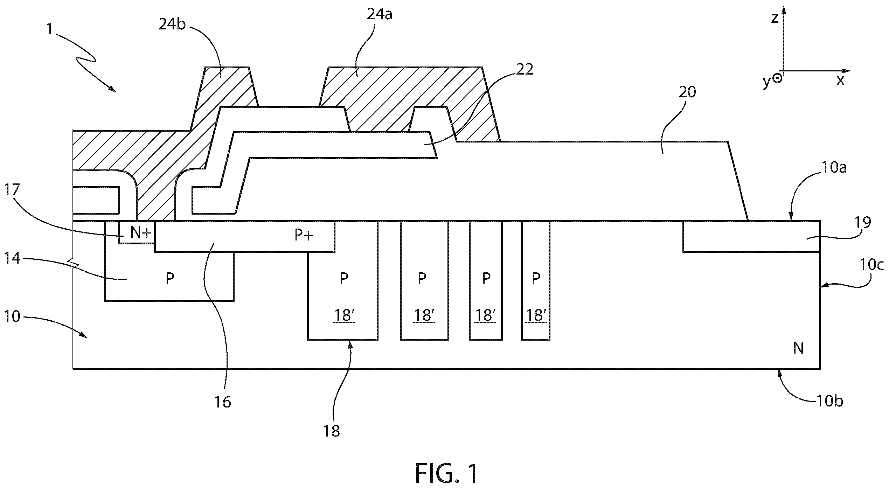

Furthermore, the use of such hard masks limits the mutual spatial distance between adjacent implants, as for example in the case of variable-transparency-type edge termination rings. Figure 1 illustrates an electronic device provided with an edge termination ring of this type, according to an embodiment which is not necessarily prior art.

With reference to Figure 1, a portion of a chip which accommodates an electronic device 1 is illustrated, for example a power MOSFET, limitedly to an edge region thereof which surrounds an active area. The chip portion of Figure 1 is illustrated in a triaxial Cartesian reference system, of axes X, Y, Z orthogonal to each other. The electronic device 1 includes: a semiconductor body 10 of SiC having a first electrical conductivity (N-type), delimited by a front side 10a and a rear side 10b opposite to each other along the axis Z; and having a lateral surface 10c which connects the front side 10a to the rear side 10b along the axis Z; a body region 14, having a second electrical conductivity (P-type) opposite to the first electrical conductivity (N-type), extending into the semiconductor body 10; a source region 17 in the body region 14; a first edge termination region 16, having the second electrical conductivity with a greater doping value than the doping value of the body region 14, which extends facing the front side 10a in electrical contact with the body region 14; a second edge termination region 18 (which is the aforementioned variable transparency ring), having the second electrical conductivity and doping value lower than the doping of the first edge termination region 16; a dielectric layer 20 on the front side 10a; a conductive layer 22 on the dielectric layer 20, forming an edge field plate of the electronic device 10; a first metallization 24a in electrical contact with the conductive layer 22 and a second metallization 24b in electrical contact with the first edge termination region 16 and with the source 17, in order to apply a predetermined bias voltage (typically in a voltage range 10-20 V) between the first and the second metallizations 24a, 24b. Figure 1 further illustrates a channel stop region 19, which extends laterally to the second edge termination region 18, in particular between the second edge termination region 18 and the lateral surface 10c. The channel stop region 19 has the function of forming an equipotential ring.

The second edge termination region 18 is formed by implanting doping species having the second electrical conductivity, and extends into the semiconductor body 10 to a depth of a few micrometers, for example up to 5 µm along the axis Z. The second edge termination region 18 comprises a plurality of implanted sub-regions 18', which extend in sequence along the axis X, separated from each other by respective portions of the semiconductor body 10. Each implanted sub-region 18' may have an extension, along the axis X, different from that of the other implanted sub-regions 18', in particular decreasing extension proceeding from the first edge termination region 16 towards the channel stop region 19.

The first and the second edge termination regions 16, 18 have the function of preventing or inhibiting the generation of an electric field of such a value as to damage the electronic device 1. In particular, the Applicant has verified that an edge termination region of the type illustrated in Figure 1 is for improving the distribution of the electric field in a device with a voltage class up to 3300 V, distributing the field lines in the edge region below the critical breakdown values of the semiconductor material used.

The formation of the second edge termination region 18 envisages in particular the use of a channeled deep ion implant, with high-energy and high-dose, to reach the desired depth while locally reversing the electrical conductivity (from N-type to P-type) of the semiconductor body 10, up to obtaining the desired doping value of the implanted sub-regions 18'. The formation of the second edge termination region 18 envisages the use of a hard mask for the deep implant of the dopants having the second electrical conductivity (P), as mentioned up to 5 µm in depth along the axis Z; however, as mentioned, a hard mask of this type limits the minimum separation dimension along the axis X between the implanted sub-regions 18', in particular it limits the mutual distance between the sub-regions 18' to values greater than 1 µm.

The need is therefore felt to overcome the drawbacks discussed above, in particular with reference to the formation of the second edge termination region 18.

This aim is achieved by an electronic device and a manufacturing method thereof, as defined in the attached claims.

For a better understanding of the present invention, reference is made to the attached drawings wherein:
- Figure 1 illustrates, in lateral sectional view, an electronic device according to an embodiment which is not an object of the present invention, limitedly to an edge region of the electronic device;
- Figure 2 illustrates, in top view, a die including an active area and an edge region of an electronic device, according to one aspect of the present invention;

- Figure 3 illustrates, in lateral sectional view along scribe line III-III of Figure 2, the electronic device accommodated by the die of Figure 2, limitedly to the edge region;
- Figure 4 illustrates, by a flowchart, steps of a manufacturing method of the electronic device of Figure 3; and
- Figure 5 illustrates, in lateral sectional view, an electronic device, limitedly to the edge region, according to a further embodiment which is based on the embodiment of Figure 3.

Preferred embodiments of the present invention are described hereinbelow, by way of non-limiting example.

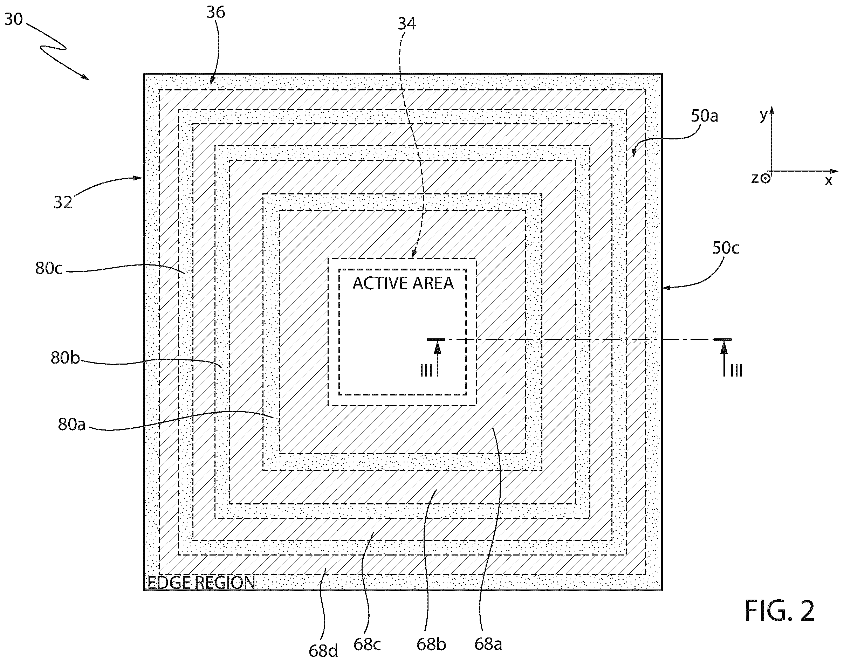

With reference to Figure 2, a die, or chip, 30, or part thereof, is illustrated in a Cartesian triaxial reference system of orthogonal axes X, Y, Z. The die 30 is obtained after a step of dicing a semiconductor wafer, not illustrated. The die 30 is shown in top view on the plane XY.

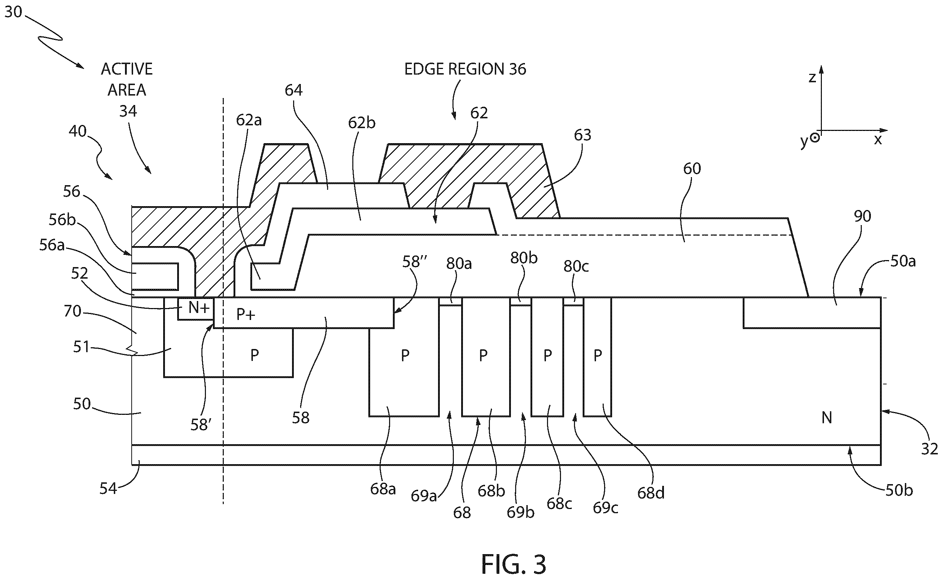

The die 30 comprises an outer edge 32 which physically delimits the die 30. The die 30 accommodates at least one electronic device 40, illustrated in part in Figure 3, such as for example a MOSFET, in particular a power MOSFET, even more in particular a vertical conduction MOSFET. In the following description, the terms "electronic device" and "MOSFET" are used interchangeably and without loss of generality.

The die 30 includes at least two functional regions: an active area 34, typically extending into a central portion of the die 30, and an edge region, or peripheral region, 36, which completely surrounds the active area 34. The edge region extends in practice between the active area 34 and the outer edge 32 and is externally delimited by the outer edge 32. The active area 34 includes the conductive channel region in use of the MOSFET 40. The edge region 36 is instead a region which does not have in use the conductive channel. The edge region 36 comprises functional elements for reducing or preventing the crowding of the electric field lines outside the active area, such as for example one or more edge termination regions, also called guard rings, as better described and illustrated with reference to Figure 3.

Figure 3 is a cross-sectional view on the plane XZ of a portion of the die 30 along scribe line III-III of Figure 2. The dashed line in Figure 3, which discriminates between the active area 34 and the edge region 36, is to be understood as qualitative.

Figure 2 illustrates only some elements of Figure 3, i.e. Figure 3 is more detailed than Figure 2.

The MOSFET 40 includes: a semiconductor body 50, in particular of silicon carbide (SiC), even more in particular of the 4H-SiC polytype. Alternatively, the semiconductor body 50 may be of 3C-SiC or 6H-SiC or of other SiC polytypes.

In general, the semiconductor body 50 is of a material having a crystalline structure or lattice configured so as to allow the ion implant by exploiting the channeled implant method (knows as channeling). Such a crystal lattice may be described through a periodic distribution of atom (or ion/molecule) groups. Ideally, considering a crystal which extends endlessly in spatial coordinates, the periodicity results in a translation invariance (or translation symmetry). The entire crystal is therefore generated by the periodic repetition of a fundamental unit, called unit cell, which may contain atom and/or ion and/or molecule groups. The translation symmetry implies that a generic point belonging to an elementary cell is in one-to-one correspondence with a point of the elementary cell obtained with a suitable translation from the first one.

The semiconductor body 50 has a first electrical conductivity (for example of N-type) and doping of the order of 1·10¹⁵-1·10²⁰ atoms/cm³. In one embodiment, the semiconductor body 50 comprises a substrate having a drift layer (not illustrated in detail in the Figures) formed (e.g., epitaxially grown) thereon. In this case, the substrate has a doping, for example, of the order of 1·10¹⁸-1·10²⁰ atoms/cm³ and the drift layer has a doping, for example, of the order of 1·10¹⁵-1·10¹⁷ atoms/cm³. The drift layer has, for example, a thickness comprised between 3 and 100 µm (range boundaries included).

The semiconductor body 50 is delimited upwardly by a front side 50a and downwardly by a rear side 50b, opposite to each other along the direction of the axis Z. A lateral surface 50c laterally delimits the die 30; the lateral surface 50c extends along the axis Z between the front side 50a and the rear side 50b, connecting the front side 50a and the rear side 50b to each other.

At the front side 50a a body region 51 is present, having a second electrical conductivity (of P-type) opposite to the first electrical conductivity. A source region 52 extends at the front side 50a into the body region 51. A drain region 54 extends at the rear side 50b. A gate region 56 extends, in a per se known manner, on the front side 50a and includes a gate dielectric 56a and a gate conductive region 56b on the gate dielectric 56a.

Figure 3 illustrates, for simplicity of representation, a single body region 51, a single source region 52 and a single gate region 56. However, it is evident that the MOSFET 40 may comprise any plurality of said body 51, source 52 and gate regions 56. In particular, the illustrated body 51, source 52 and gate regions 56 extend in proximity of the end of the active area 34.

The MOSFET 40 also comprises, within the semiconductor body 50, a first edge termination region 58, implanted at the front side 50a and facing the front side 50a. The first edge termination region 58 has the second electrical conductivity and doping (P+) greater than that of the body region 51. The first edge termination region 58 includes an end portion (or end region) 58' extends within the edge region 36 (and optionally in part also into the region of active area 34); the first edge termination region 58 is therefore in direct electrical contact with the body region 51. The first edge termination region 58 has, when biased to the body and source voltage, the function of shielding the structures of the device, which extend above the edge termination region 58 (in particular, the portion 62a of the conductive layer 62 described hereinbelow), from high electric fields. The source region 52 may be omitted within the body region 51 which, as illustrated in Figure 3, is in direct electrical contact with the first edge termination region 58.

A field dielectric layer ("field oxide") 60 extends above the first edge termination region 58 (on the front side 50a) and a conductive layer 62 (for example of metal or N-type doped polysilicon) extends on the dielectric layer 60. Layer 62 is configured to distribute the gate bias to the device (the gate conductive region 56b is in electrical connection with the layer 62).

The conductive layer 62 includes: a first portion 62a which extends over the first edge termination region 58 and is electrically insulated from the latter by a dielectric or oxide (e.g., SiO₂) layer; and a second portion 62b which extends above the dielectric layer 60. The first and the second portions 62a, 62b are in mutual structural and electrical continuity. The second portion 62b forms an edge field plate, of the MOSFET 40, as it takes the gate potential to the edge termination region 36.

The conductive layer 62 is (in a manner not illustrated in the Figure) in electrical connection with the gate conductive region 56b and, in particular, it is formed during the same step of forming the gate conductive region 56b. A passivation layer 64 extends on the conductive layer 62, to protect and insulate the conductive layer 62. The passivation layer 64 is interrupted where the metallization 63 is in electrical contact with the conductive layer 62.

With joint reference to Figures 2 and 3, the MOSFET 40 comprises a second edge termination region 68 (or second edge ring 68) having the second electrical conductivity (of P-type) and lower doping value than the doping value of the first edge termination region 58 (or first edge ring 58). The second edge termination region 68 extends at an end portion (or "end region") 58" of the first edge termination region 58, opposite to the end portion 58' which extends within the body region 51. The second edge termination region 68 therefore extends as an extension of the first edge termination region 58 and is in direct electrical contact with the first edge termination region 58. The second edge termination region 68 has the function of distributing or thinning the field lines of the electric potential in such a way as to avoid a thickening of the field lines on the curvature radius of the first edge termination region 58, and thus maximizing the value of the edge breakdown voltage, similarly to what has been described with reference to Figure 1.

Figure 3 further illustrates a channel stop region 90, optional, which extends laterally to the second edge termination region 68, at and facing the front side 50a. The channel stop region 90 extends in particular between the second edge termination region 68 and the lateral surface 50c of the die 30. The channel stop region 90 is formed by implant of doping species having the first conductivity (N-type, for example obtained by doping with phosphorus) and dopant dose comprised between 1·10¹⁹ and 5·10²⁰ atoms/cm³. The channel stop region 90 has the function of forming an equipotential ring with the drain on the die edge.

The doping density of the first edge termination region 58 is of the order of 1·10¹⁸-1·10²⁰ atoms/cm³. The doping density of the second edge termination region 68 is of the order of 1·10¹⁶-1·10¹⁸ atoms/cm³.

The thickness of the first edge termination region 58, along the direction Z starting from the front side 50a, is for example comprised between 0.3 and 1 µm (boundaries included). The thickness of the second edge termination region 68, along the direction Z starting from the front side 50a, is for example comprised between 0.5 µm and 5 µm (range boundaries included) in particular between 1 and 5 µm (range boundaries included).

According to one aspect of the present invention, as illustrated in Figures 2 and 3, the second edge termination region 68 comprises a plurality of sub-regions 68a-68d (indicated as a whole with the reference numeral 68), which extend (in the representation of Figure 3) along the axis X separated from each other by respective portions 69a-69c (having the first electrical conductivity, here of N-type) of the semiconductor body 50. In a non-limiting manner of the present invention, each sub-region 68a-68d has an extension, along the axis X, different from that of the other sub-regions 68a-68d, in particular a decreasing extension proceeding from the first edge termination region 58 towards the channel stop region 90.

It becomes apparent from the plan view of Figure 2 that the sub-regions 68a-68d surround the active area, in particular completely surround the active area and therefore what is represented in Figure 3 (limitedly to the shape and extension of the sub-regions 68a-68d, along the axis X) applies similarly to a section taken along the axis Y.

Figure 3 illustrates four sub-regions 68a-68d, but this representation is not to be considered limiting of the present invention, as the number of sub-regions 68a-68d may be chosen in the design step as needed, for example equal to two or greater than two (e.g., between two and six).

The sub-region 68a is in direct electrical connection with the first edge termination region 58, i.e. the end portion 58" of the first edge termination region 58 extends within the sub-region 68a. The sub-region 68b extends laterally to the sub-region 68a, separated from the latter by the portion 69a of the semiconductor body 50. The distance, along the axis X, between the sub-region 68a and the sub-region 68b is equal to 1 µm or lower than 1 µm, for example comprised between 0.25 and 1 µm. Similarly, the sub-region 68c extends laterally to the sub-region 68b, separated from the latter by the portion 69b of the semiconductor body 50. The distance, along the axis X, between the sub-region 68b and the sub-region 68c is equal to 1 µm or lower than 1 µm, for example comprised between 0.25 and 1 µm. Similarly, the sub-region 68d extends laterally to the sub-region 68c, separated from the latter by the portion 69c of the semiconductor body 50. The distance, along the axis X, between the sub-region 68c and the sub-region 68d is equal to 1 µm or lower than 1 µm, for example comprised between 0.25 and 1 µm.

The aforementioned distances, along the axis X, between the sub-regions 68a-68d may be equal to each other or different from each other. The design requirements dictated by the net epitaxial concentrations may envisage values of the distances, along the axis X between the sub-regions 68a-68d, greater than 1 µm, for example up to 3 µm.

The sub-regions 68a-68d all face the front side 50a and end within the semiconductor body 50, without reaching the rear side 50b.

According to one aspect of the invention, respective damaged regions 80a-80c extend between the sub-regions 68a-68d; the damaged regions 80a-80c face the front side 50a and end within the semiconductor body 50, in a respective portion 69a-69c.

It should be noted, with reference to Figure 2, that the damaged regions 80a-80c also extend to surround, completely or partially, the active area 34. The representation of the damaged regions 80a-80c of Figure 3 relates to the section along the axis X of Figure 2, but similarly applies to a section along the axis Y of Figure 2.

In particular, the damaged region 80a extends into the portion 69a between the sub-region 68a and the sub-region 68b, and is adjacent to the sub-region 68a and the sub-region 68b; the damaged region 80b extends into the portion 69b between the sub-region 68b and the sub-region 68c, and is adjacent to the sub-region 68b and the sub-region 68c; the damaged region 80c extends into the portion 69c between the sub-region 68c and the sub-region 68d, and is adjacent to the sub-region 68c and the sub-region 68d. Even more in particular, the damaged region 80a extends exclusively in correspondence of the portion 69a; analogously, the damaged region 80b extends exclusively in correspondence of the portion 69b; and the damaged region 80c extends exclusively in correspondence of the portion 69c.

The Applicant has verified that the channeling effect is altered by an intentional damage to a region of the surface of the semiconductor body 50, at the front side 50a, i.e. whereat the channeled implant for forming the sub-regions 68a-68b occurs. The damaged regions 80a-80c are therefore obtained by intentional damage obtained, for example, by ion implant of non-reactive or non-doping species, in the semiconductor body 50, exclusively at the portions thereof wherein it is desired to form the damaged regions 80a-80c, or at the portions 69a-69c. The ion implant is such as to cause damage to the crystal lattice of the semiconductor body 50, without locally altering the conductive characteristics thereof. Chemical species suitable for this purpose include for example ions of Si, Ar, Ge, He.

Where present, the damaged regions 80a-80c alter or inhibit the channeling effect during the formation of the second edge termination region 68, giving it the shape illustrated in Figure 3 and described above (i.e. forming the succession of the sub-regions 68a-68d physically separated from each other).

The damaged region 80a-80c extend to a maximum depth, in the semiconductor body 50 starting from the front side 50a, comprised for example between 0.1 and 0.6 µm (boundaries included). In one embodiment, the thickness of the damaged regions 80a-80c is uniform; in a further embodiment, the thickness of the damaged region 80a-80c is not uniform but varies between a maximum value of 0.6 µm and a minimum value of 0.1 µm.

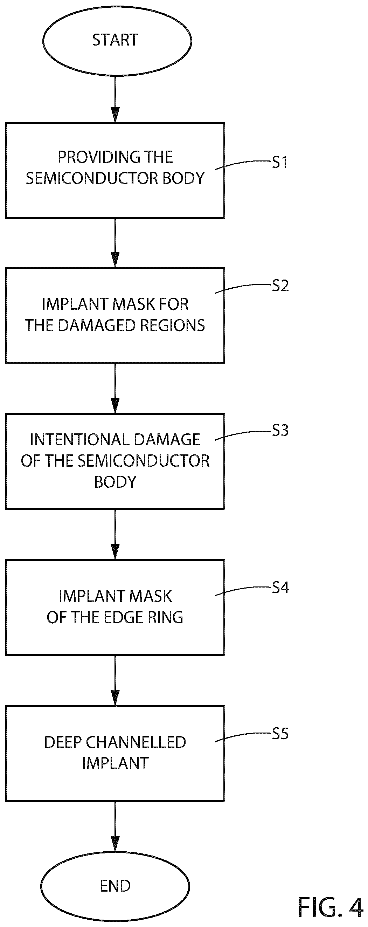

Figure 4 illustrates, by a flowchart, steps of a manufacturing process of the MOSFET 40, limitedly to the elements useful to understand the present invention.

Therefore, with reference to step S1 of Figure 4, the semiconductor body 50 is arranged or formed and, before the formation of the layers 60 and 62 previously described, an implant mask (step S2), for example of photoresist or dielectric material, is formed on the front side 50a. This implant mask is patterned so as to cover the front side 50a with the exception of the regions 69a-69c wherein it is desired to form the damaged regions 80a-80c, which therefore remain unmasked.

Then, step S3, the damaged regions 80a-80c are formed, as described above, exploiting the implant mask. It is noted that the formation of this implant mask does not unduly limit the minimum dimension, along the axis X, of the damaged regions 80a-80c, as the depth of these regions (lower than one micrometer) does not require high implant energies, and it is therefore possible to exploit masking materials that allow good definition to be obtained (unlike the hard masks used for deep implants, of several micrometers, as described with reference to Figure 1).

To complete what has been said for the formation of the damaged regions 80a-80c, forming the damaged regions 80a-80c comprises using implant doses greater than 10¹³ atoms/cm² and energies sufficient to cause the atoms to shift from the crystal structure throughout the necessary depth (e.g., energy in the range 30-300 keV, boundaries included). The implant that introduces the damage is not performed in channeling conditions and the annealing of the wafer during the process is avoided not to remove the damage produced. According to a further embodiment, the damaged regions 80a-80c are formed by one or more steps of etching the front side 50a of the semiconductor body 50, for example a RIE (Reactive Ion Etching) process with physical etching characteristics (ion bombardment), masking the regions of the semiconductor body 50 which are not to be subject to the intentional damage process.

Then, step S4, the second edge termination region 68 is formed. This step includes forming a hard mask (for example one or more natural oxide layers or one or more intentionally added oxide layers) on the surface 50a laterally to the series of damaged regions 80a-80c (i.e. surrounding the damaged regions 80a-80c). The hard mask of step S4 covers the surface 50a with the exception of the portions thereof which correspond to the damaged regions 80a-80c (i.e. the portions 69a-69c) and with the exception of the portions of the surface 50a at which it is desired to form the sub-regions 68a-68d. In other words, forming the mask of step S4 envisages forming this mask at a distance from the damaged regions 80a and 80c which are the outermost damaged regions of the series of damaged regions 80a-80c, the other damaged regions (here, 80b) being all comprised between such external damaged regions 80a, 80c. The distance between the mask and the external damaged regions 80a, 80c is chosen in the design step based on the extension, along X, desired for the corresponding sub-regions 68a and 68d, which are also the outermost sub-regions of the series of the sub-regions 68a-68d (the other sub-regions 68b, 68c being all comprised between these external sub-regions 68a and 68d).

Then, step S5, the method proceeds with a channeled implant of doping species having the second electrical conductivity at the front side 50a, forming the second edge termination region 68.

Following the steps S1-S5 described, the structure of the MOSFET 40 is completed, as regards the edge region 36, with the formation of the field dielectric layer ("field oxide") 60, the conductive layer 62, the metallization 63 and the passivation layer 64.

With reference to step S5, the channeled implant occurs when the ion beam during implant is aligned with the channeling directions. For example, in SiC, the 000-1 or 11-23 direction. Typically the substrates are cut from ingots grown in the 000-1 direction with a surface inclined (for dicing wafers) by 4° for substrates having a diameter of 150 mm or 200 mm. This entails that to implant with channeling on a 000-1 wafer it is necessary to tilt the ion beam during the implant with tilt of 4°, and for a 11-23 wafer of 13° or 21°.

As a result of the two possible damaging steps mentioned above, the semiconductor body 50 does not have, at the damaged regions 80a-80c, the same lattice structure as the semiconductor body 50 which extends laterally to the damaged regions 80a-80c. In particular, the semiconductor body 50, where intentionally damaged, has an amorphous structure or a disordered structure or a structure with no spatial symmetry that characterizes instead the unintentionally damaged portions of the semiconductor body 50. The channeling effect is altered by the presence of the damaged regions 80a-80c as well as by the presence of a masking surface layer arranged over the front side 50a of the semiconductor body 50.

The advantages of the present invention are evident from what has been previously described. In particular, according to the present invention, using a hard mask in step S3 in Figure 4 is not necessary. Furthermore, forming the edge termination regions 58, 68 does not require using a high-energy and high-dose ion implant to reach the desired depth and electrical conductivity.

Finally, it is clear that modifications and variations may be made to what has been described and illustrated herein without thereby departing from the scope of the present invention, as defined in the attached claims.

For example, the present invention applies to an electronic device other than a vertical channel MOSFET, such as for example a horizontal channel MOSFET, a trenchFET, a diode, a triristor, a MESFET, a MISFET, an IGBT.

Furthermore, the semiconductor body 50 may be a material other than SiC, such as for example GaN.

Furthermore, the semiconductor body 50 may comprise a substrate of semiconductor material (SiC, GaN, etc.) and optionally one or more epitaxial surface layers grown on the substrate.

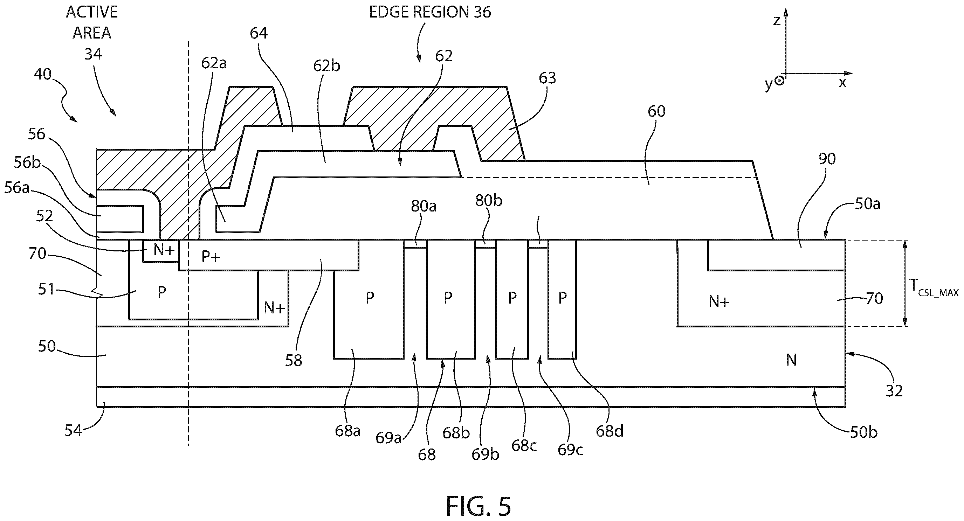

Furthermore, in one embodiment, the body region 51 shown in Figures 3 and 5, i.e. the body region in direct electrical connection with the first edge termination region 58, does not accommodate the source region 52. In fact, in this embodiment, the illustrated body region 51 extends to the border with the edge region 36, i.e. in proximity of an area of the device 40 designed not to participate in the electrical conduction; the absence of the source region prevents the flow of charge carriers (conduction current) towards the edge region 36.

Furthermore, as previously mentioned, the second edge termination region 68 may comprise only two sub-regions, for example the sole sub-regions 68a and 68b. In this case, only one damaged region (the damaged region 80a) is present, which extends between the sub-region 68a and the sub-region 68b.

The MOSFET 40 (or other device manufactured according to the invention) may optionally comprise also a Current Spreading Layer (CSL) 70, which extends into the semiconductor body 50 facing the front side 50a. See Figure 5, wherein elements corresponding to those of Figure 3 are identified with the same reference numeral and not further described. The CSL 70 has a maximum thickness T_{CSL_MAX}, starting from the front side 50a, comprised between 0.3 and 2 µm along the axis Z (boundaries included). In general, the CSL 70 has a depth equal to that of the body 51, or extends below the body 51 by a value up to 1 µm. In one embodiment, the maximum depth reached by the CSL 70 is greater than the maximum depth reached by the body region 51. Thus, in this case, the body region 51 is completely contained in the CSL 70. The CSL 70 forms an enrichment layer having the function of improving the value of the on-state resistance (known as Ron) of the MOSFET 40. The doping of the CSL 70 is greater than the doping of the semiconductor body 50. The CSL 70 has, for example, doping of the order of 10¹⁷ atoms/cm³ or comprised between 2 and 20 times the doping of the portion of the semiconductor body 50 accommodating it. The CSL 70 may have a uniform or non-uniform thickness along the axis Z starting from the front side 50a. In particular, the CSL 70 may have maximum thickness at the active area 34 (where it performs its function of reducing Ron) and a lower thickness at a portion of the second edge termination region 68. The CSL 70 may be formed by using a channeled ion implant.

## Claims

1. An electronic device (40), comprising:
- a semiconductor body (50), having a first electrical conductivity (N) and a first doping value, and provided with a front side (50a), wherein the semiconductor body (50) is of a semiconductor material having a crystalline structure or a lattice structure with spatial symmetry;
- an active area (34) configured to accommodate, in use, a conductive channel of the electronic device;
- an edge region (36), surrounding the active area (34) and in structural continuity with the active area (34), and accommodating at least in part:
a first edge termination region (68) having a second electrical conductivity (P) opposite to the first electrical conductivity (N) and which extends into the semiconductor body (50) starting from the front side (50a), said first edge termination region (68) comprising at least a first and a second sub-region (68a, 68b) having a second electrical conductivity (P), separated from each other by a portion (69a) of the semiconductor body (50) having the first electrical conductivity (N); and
a damaged region (80a) extending exclusively at the portion (69a) of the semiconductor body between the first and the second sub-regions (68a, 69a), facing the front side (50a), the damaged region (80a) having an amorphous structure or a structure with no said spatial symmetry.

2. The electronic device (40) according to claim 1, wherein the first and the second sub-regions (68a, 68b) of the first edge termination region (68) extend to respective maximum depths comprised between 1 and 5 µm starting from the front side (50a) and along a first direction (Z) orthogonal to the front side (50a), in particular said maximum depths of the first and the second sub-regions (68a, 68b) being equal to each other.

3. The electronic device (40) according to claim 1 or 2, wherein the first and the second sub-regions (68a, 68b) of the first edge termination region (68) have a respective extension, along a second direction (X; Y) orthogonal to the first direction (Z), different from each other.

4. The electronic device (40) according to any of the preceding claims, wherein the first and the second sub-regions (68a, 68b) of the first edge termination region (68) have a same doping value.

5. The electronic device (40) according to any of the preceding claims, wherein the active area (34) comprises at least one body region (51) having the second electrical conductivity (P), wherein the first sub-region (68a) of the edge termination region (68) is in electrical connection with the body region and has a greater doping than the respective doping of the body region.

6. The electronic device (40) according to claim 5, further comprising a second edge termination region (58) having the second electrical conductivity (P), extending between the first sub-region (68a) of the edge termination region (68) and the body region (51), wherein the first sub-region (68a) of the edge termination region (68) and the second edge termination region (58) are in mutual electrical continuity.

7. The electronic device (40) according to claim 5 or 6, wherein the second sub-region (68b) extends to a distance from the body region (51), along the second direction (X; Y), greater than the corresponding distance between the first sub-region (68a) and the body region (51),
said second sub-region (68b) having an extension, along the second direction (X; Y), smaller than the corresponding extension of the first sub-region (68a).

8. The electronic device (40) according to claim 6 or 7, wherein the second edge termination region (58) has a greater doping than the doping of the first edge termination region (68) and is in direct electrical contact with the body region (51),
and wherein the first sub-region (68a) of the edge termination region (68) is in direct electrical contact with the second edge termination region (58).

9. The electronic device (40) according to any of the preceding claims, wherein said damaged region (80a) accommodates non-reactive or non-doping ion species, such as for example Si, Ar, Ge, He.

10. The electronic device (40) according to any of the preceding claims, wherein said damaged region (80a) extends into the semiconductor body (50), starting from the front side (50a), for a maximum depth, along the first direction (Z), which is lower than the maximum depth of the first edge termination region.

11. The electronic device (40) according to claim 10, wherein the depth value of the damaged region (80a) is comprised between 0.1 and 0.6 µm.

12. The electronic device (40) according to any of the preceding claims, wherein the semiconductor body (50) is of Silicon Carbide, in particular of 3C-SiC, 4H-SiC, 6H-SiC.

13. A method for manufacturing an electronic device (40), comprising the steps of:
- arranging a semiconductor body (50), having a first electrical conductivity (N) and a first doping value, and provided with a front side (50a), wherein the semiconductor body (50) is of a semiconductor material having a crystal structure or a lattice structure with spatial symmetry, the semiconductor body having an active area (34) configured to accommodate, in use, a conductive channel of the electronic device and an edge region (36), surrounding the active area (34) and in structural continuity with the active area (34), the method comprising the steps of:
- forming, at a portion (69a) of the front side (50a), a damaged region (80a) having an amorphous structure or a structure with no said spatial symmetry;
- forming a first edge termination region (68) having a second electrical conductivity (P), opposite to the first electrical conductivity (N), in the semiconductor body (50) starting from the front side (50a), including:
performing a channeled implant of doping species having the second electrical conductivity (P) at the damaged region (80a) and at portions of the semiconductor body adjacent to opposite sides of the damaged region (80a).

14. The method according to claim 13, wherein the channeled implant causes the formation of at least a first and a second sub-region (68a, 68b) having a second electrical conductivity (P) separated from each other by said portion (69a) of the semiconductor body (50).

15. The method according to claim 14, wherein the first and the second sub-regions (68a, 68b) extend up to respective maximum depths comprised between 1 and 5 µm starting from the front side (50a) and along a first direction (Z) orthogonal to the front side (50a), in particular said maximum depths of the first and the second sub-regions (68a, 68b) being equal to each other.

16. The method according to any of claims 13-15, wherein the step of forming the damaged region (80) comprises performing an implant of non-reactive or non-doping ion species, such as for example Si, Ar, Ge, He, in particular using the following parameters: implant energy comprised between 30 keV and 300 keV; implant dose of the order of 10¹³ atoms/cm²;
alternatively: wherein the step of forming the damaged region (80) comprises performing an etching.

17. The method according to any of claims 13-15, wherein the step of forming the damaged region (80a) comprises forming the damaged region (80a) with a maximum depth value comprised between 0.1 and 0.6 µm.
